# EUROPEAN PATENT APPLICATION

(11) **EP 4 307 283 A1**
(43) Date of publication of application: **17.01.2024**
(21) Application number: 22766682.3
(22) Date of filing: 02.02.2022
(51) Int. Cl.: G09G 3/20, G09G 3/32, H01L 33/00, G09F 9/30, H01L 27/32, H01L 51/50

(54) **DISPLAY DEVICE AND CONTROL METHOD**

(30) Priority: 11.03.2021 JP 2021039352
(71) Applicant: Sony Semiconductor Solutions Corporation, Atsugi-shi, Kanagawa 243-0014 (JP)
(72) Inventor: TOYOMURA Naobumi, Atsugi-shi, Kanagawa 243-0014 (JP); YOKOYAMA Kazuki, Atsugi-shi, Kanagawa 243-0014 (JP)
(74) Representative: D Young & Co LLP
(86) International application number: PCT/JP2022/003920
(87) International publication number: WO 2022/190716

(57) **Abstract**

A display device having a long life and high reliability.

The display device includes a control circuit. The control circuit controls a transistor to be turned off in a case where a light emitting element emits light, the transistor being connected to a terminal to which signals for determining driving and light emission intensity of the light emitting element are applied and initializing the signal for determining the light emission intensity, and controls the transistor to be turned on and then controls the transistor to be turned off in a case where the light emitting element shifts to an extinction state.

## Description

### TECHNICAL FIELD

The present disclosure relates to a display device and a control method.

### BACKGROUND ART

Today, in a wide field, there is a growing demand for organic light emitting diodes (OLEDs), particularly micro OLED (M-OLED) devices, as light emitting elements. With an increase in demand in various devices, there is also an increase in demand for driving a light emitting element with a low duty. For example, in a device such as augmented reality (AR), virtual reality (VR), a TV, or a digital camera, a duration of lighting or extinction of pixels is often long.

Currently, in a major M-OLED device, a high load is applied to some transistors in a pixel of a light emitting element during extinction in some cases. The presence of the high-load time causes a problem that the longer the extinction period, the shorter the life of a predetermined transistor that controls the light emitting element in low-duty driving.

### CITATION LIST

### PATENT DOCUMENT

Patent Document 1: Japanese Patent Application Laid-Open No. 2019-211775

### SUMMARY OF THE INVENTION

### PROBLEMS TO BE SOLVED BY THE INVENTION

Therefore, the present disclosure provides a display device having a long life and high reliability.

### SOLUTIONS TO PROBLEMS

According to an embodiment, a display device includes a control circuit. The control circuit controls a transistor to be turned off in a case where a light emitting element emits light, the transistor being connected to a terminal to which signals for determining driving and light emission intensity of the light emitting element are applied and initializing the signal for determining the light emission intensity, and controls the transistor to be turned on and then controls the transistor to be turned off in a case where the light emitting element shifts to an extinction state.

The control circuit may control the transistor to be turned off after the signal for determining the light emission intensity is initialized after the light emitting element shifts to the extinction state and the transistor is controlled to be turned on.

The control circuit may control the transistor to be turned on at a predetermined timing after the transistor is controlled to be turned off in a case where the light emitting element is in the extinction state.

The light emitting element may be an element that emits light by passing a current from an anode to a cathode, and the transistor may be connected to the anode of the light emitting element.

The transistor may be a p-type MOSFET, a source may be connected to the anode, a reference voltage may be applied to a drain, and a voltage for controlling on and off of the transistor may be applied to a gate.

The transistor may be an n-type MOSFET, a drain may be connected to the anode, a reference voltage may be applied to a source, and a voltage for controlling on and off of a transistor may be applied to the gate.

According to an embodiment, a display method of a display device is a method of controlling a transistor to be off in a case where a light emitting element emits light, the transistor being connected to a terminal to which signals for determining driving and light emission intensity of the light emitting element are applied and initializing the signal for determining the light emission intensity, and controlling the transistor to be off after the transistor is controlled to be on in a case where the light emitting element shifts to an extinction state.

According to an embodiment, the control circuit performs the process described above in the display device.

According to an embodiment, a pixel circuit includes the control device described above.

In the display device, the control circuit described above may be used for an AR application, a VR application, and a display application of a digital camera.

### BRIEF DESCRIPTION OF DRAWINGS

Fig. 1 is a diagram illustrating an example of part of a display device according to an embodiment.
Fig. 2 is a diagram illustrating an example of a pixel according to an embodiment.
Fig. 3 is a diagram illustrating an example of a timing chart according to an embodiment.
Fig. 4 is a diagram illustrating an example of the timing chart according to the embodiment.
Fig. 5 is a diagram illustrating an example of the display device according to the embodiment.
Fig. 6 is a diagram illustrating an example of the pixel according to the embodiment.
Fig. 7 is a diagram illustrating an example of the pixel according to the embodiment.
Fig. 8 is a diagram illustrating an example of the pixel according to the embodiment.
Fig. 9 is a diagram illustrating an example of the pixel according to the embodiment.
Fig. 10A is a front view illustrating an example of an external appearance of a digital still camera.
Fig. 10B is a rear view illustrating an example of the external appearance of the digital still camera.
Fig. 11 is a perspective view illustrating an example of an external appearance of a head mounted display.
Fig. 12 is a perspective view illustrating an example of an external appearance of a television device.
Fig. 13 is an external view illustrating an example of the head mounted display.
Fig. 14 is an external view illustrating an example of a smartphone.
Fig. 15A is an external view illustrating an example of an image display device in a transport.
Fig. 15B is an external view illustrating the example of the image display device in the transport.

### MODE FOR CARRYING OUT THE INVENTION

Hereinafter, embodiments of the present disclosure will be described with reference to the drawings. The drawings are used for description, and the shape and size of the configuration of each unit in the actual device, the ratio of the size to other configurations, and the like are not necessarily as illustrated in the drawings. Furthermore, since the drawings are illustrated in a simplified manner, configurations necessary for implementation other than those illustrated in the drawings are appropriately provided.

Note that, in a circuit diagram, connection with a power supply for driving each circuit element is not particularly illustrated; however, description and illustration thereof are merely omitted, and connection and installation of the power supply are appropriately performed as necessary. Furthermore, an appropriate body voltage is applied to the body of a transistor unless otherwise specified. Moreover, in each embodiment, the transistors are described as n-type and p-type, but the present invention is not limited to the contents of the drawings and the description of the present Description, and the n-type and the p-type may be switched as appropriate. In this case, a voltage for appropriate driving is applied.

As an example, a display device having a display panel that emits light in a progressive system will be described; however, an embodiment of the present disclosure can also be applied to a display panel and a display device in other forms.

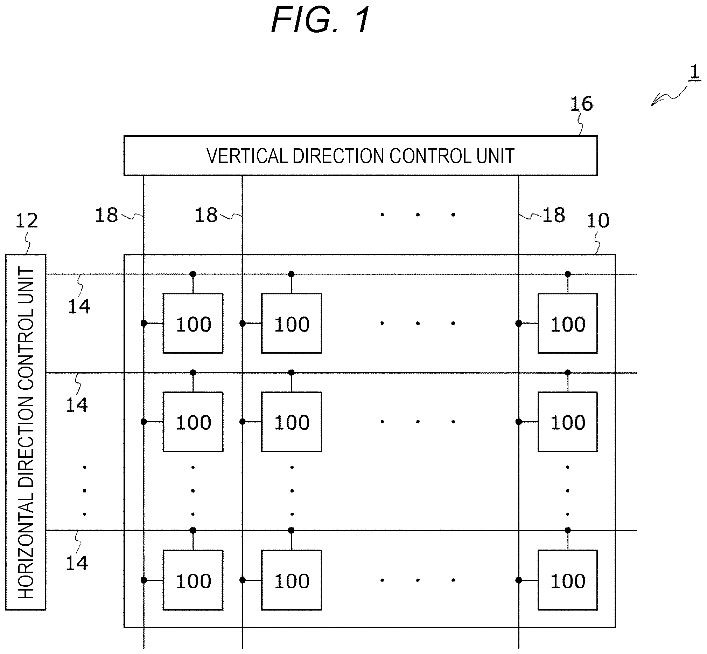

Fig. 1 is a diagram illustrating an example of arrangement and the like of pixels in a general display device.

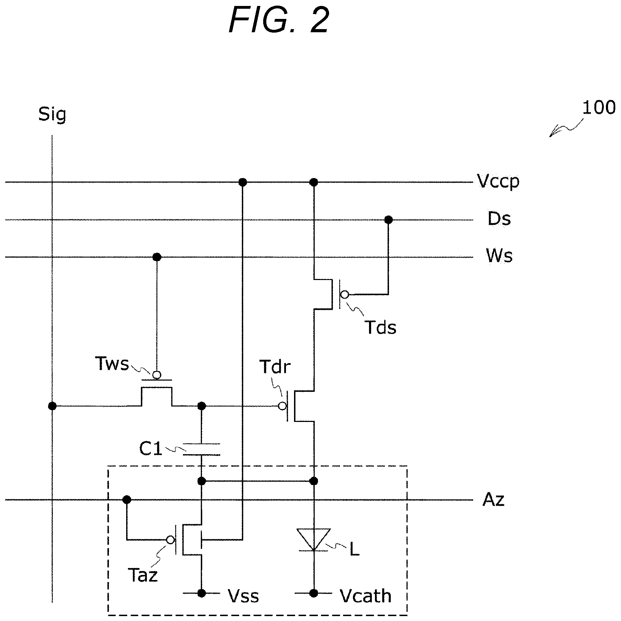

A display device 1 includes, for example, a pixel array 10, a horizontal direction control unit 12, and a vertical direction control unit 16. Note that the horizontal direction and the vertical direction in Fig. 1 are directions given for convenience, and the longitudinal direction and the lateral direction in the drawing may have an opposite relationship or may be inclined in an arbitrary direction. Furthermore, the horizontal direction and the vertical direction do not need to intersect strictly at 90 degrees. For example, it is not necessary that the horizontal direction and the vertical direction in Fig. 2 and subsequent drawings are at least partially coincide with the horizontal direction and the vertical direction in Fig. 1.

The pixel array 10 includes pixels 100 in an array in the horizontal direction and the vertical direction. The pixel array 10 executes output of an image, a video, or the like in the display device 1.

The pixel 100 includes a light emitting element and a circuit element such as a transistor for appropriately emitting light from the light emitting element. Furthermore, as the pixel 100, an optical system may be provided so that light emitted from the light emitting element is appropriately output from the display device 1.

The horizontal direction control unit 12 collectively outputs a signal to a row of the pixels 100 continuous in the horizontal direction belonging to the pixel array 10. The horizontal direction control unit 12 is connected to a horizontal direction control line 14, and the horizontal direction control line 14 is connected to the pixels 100 continuous with a row in the horizontal direction. A signal is output from the horizontal direction control unit 12 to the pixels 100 in the horizontal direction via the horizontal direction control line 14.

The vertical direction control unit 16 collectively outputs a signal to a column of the pixels 100 continuous in the vertical direction belonging to the pixel array 10. The vertical direction control unit 16 is connected to a vertical direction control line 18, and the vertical direction control line 18 is connected to the pixels 100 continuous with a column in the vertical direction. A signal is output from the vertical direction control unit 16 to the pixels 100 in the vertical direction via the vertical direction control line 18.

Each of the pixels 100 is lit or the like by the horizontal direction control unit 12 and the vertical direction control unit 16, so that a video or the like is generated and output from the display device 1. In Fig. 1, one signal line is provided in each of the horizontal direction and the vertical direction; however, a plurality of different types of signals may be provided.

Next, the pixel 100 will be described in more detail.

Fig. 2 is a diagram illustrating a configuration example of the pixel according to an embodiment. The pixel 100 includes, for example, a light emitting element L, and includes a circuit for causing the light emitting element L to emit light.

As a general simple example, the pixel 100 includes a first transistor Taz, a second transistor Tws, a third transistor Tds, a fourth transistor Tdr, and a first capacitor C1.

The light emitting element L is, for example, an LED element such as an LED, an OLED, or an M-OLED. In the following description, the light emitting element L is an element such as these LEDs; however, is not limited thereto, and a similar form can be applied as long as the light emitting element L is an element that emits light when a voltage is applied or when a current flows. The light emitting element L emits light when a current flows from the anode to the cathode. The cathode is connected to a reference voltage Vcath (for example, 0 V). The anode of the light emitting element L is connected to the source of the first transistor Taz, the drain of the fourth transistor Tdr, and one terminal of the first capacitor C1.

The first transistor Taz is, for example, a p-type metal-oxide-semiconductor field-effect transistor (MOSFET), and has a source connected to the anode of the light emitting element L, a drain connected to a voltage Vss, and a gate to which a signal Az is applied. The first transistor Taz is a transistor that initializes the potential of the anode of the light emitting element L according to the signal Az. The voltage Vss is, for example, a reference voltage at the power supply voltage, and may represent a grounded state or may be a potential of 0 V.

The first capacitor C1 is a capacitor for controlling the potential on the anode side of the light emitting element L.

The second transistor Tws is, for example, a p-type MOSFET, and is a transistor that controls writing of a pixel value. In the second transistor Tws, a signal Sig indicating a pixel value is input to the source, the drain is connected to the other end of the first capacitor C1 and the gate of the fourth transistor Tdr, and a signal Ws for write control is applied to the gate. The second transistor Tws causes a drain current according to the signal Sig to flow by the signal Ws, and controls writing to the first capacitor C1 and the gate potential of the fourth transistor Tdr. When the second transistor Tws is turned on, a voltage based on the magnitude of the signal Sig is charged (written) in the first capacitor C1, and the light emission intensity of the light emitting element L is controlled by the charge amount of the first capacitor C1.

The third transistor Tds is, for example, a p-type MOSFET, and is a transistor that controls driving of passing a current based on a potential corresponding to the written pixel value to the light emitting element L. The third transistor Tds has a source connected to a power supply voltage Vccp for driving the MOS, a drain connected to the source of the fourth transistor Tdr, and a gate to which a drive signal Ds is applied. A drain current flows according to the drive signal Ds, and the drain potential of the fourth transistor Tdr is raised.

The fourth transistor Tdr is, for example, a p-type MOSFET, and passes a current based on the signal Sig written by the second transistor Tws to the light emitting element L by driving the third transistor Tdr. The fourth transistor Tdr has a source connected to the drain of the third transistor Tds, a drain connected to the anode of the light emitting element L, and a gate connected to the drain of the second transistor Tws. In the fourth transistor Tdr, since the signal Sig stored by the second transistor Tws and the first capacitor C1 is applied to the gate, the source potential becomes a sufficiently large value. Therefore, a drain current corresponding to the signal Sig flows. When the drain current flows, the light emitting element L emits light with intensity (luminance) corresponding to the signal Sig.

As a simple example, the pixel 100 emits light by performing writing based on the signal Sig for determining the light emission intensity for each pixel and passing a drain current corresponding to the intensity of the written signal to the light emitting element L in this manner.

The first transistor Taz is a transistor that performs a quick discharge operation at a timing after light emission to initialize a written state. The body of the first transistor Taz needs to be held at a sufficiently large potential for appropriate driving while the pixel 100 operates (light emission, extinction), and for example, the power supply voltage Vccp is applied.

Since the first transistor Taz is turned off while the light emitting element L emits light, a voltage sufficiently higher than a threshold voltage is applied to the gate. In a case where the first transistor Taz is an n-type, a voltage sufficiently lower than the threshold voltage is applied to the gate. Hereinafter, the case of the p-type will be described; however, in the case of the n-type, it is assumed that the voltage applied to the gate is appropriately replaced. In a case where the light emitting element L emits light, for example, a voltage higher than the voltage Vccp is applied to the gate of the first transistor Taz. As an example, the voltage Vccp is 9 V, and a voltage of 10 V is applied to the first transistor Taz in the light emitting state.

In contrast, while the light emitting element L is quenched, there is a timing at which the first transistor Taz is turned on to discharge the written charge. At this on timing, the gate of the first transistor Taz is desirably set to a potential sufficiently lower than the threshold voltage. For example, a voltage (for example, 0 V) equivalent to the voltage Vss is applied to the gate of the first transistor Taz.

In this case, in the first transistor Taz, for example, a voltage of 9 V is applied to the body and a voltage of 0 V is applied to the gate. Therefore, there is a possibility that the time during which a high voltage is applied between the body and the gate of the first transistor Taz becomes long. The longer this time, the higher the possibility that the life of the first transistor Taz becomes shorter and furthermore the performance is lowered. As a result of lowered performance of the first transistor Taz, appropriate charging and discharging cannot be executed in the pixel 100 is some cases. In the present disclosure, the discharge timing of the first transistor Taz is appropriately controlled.

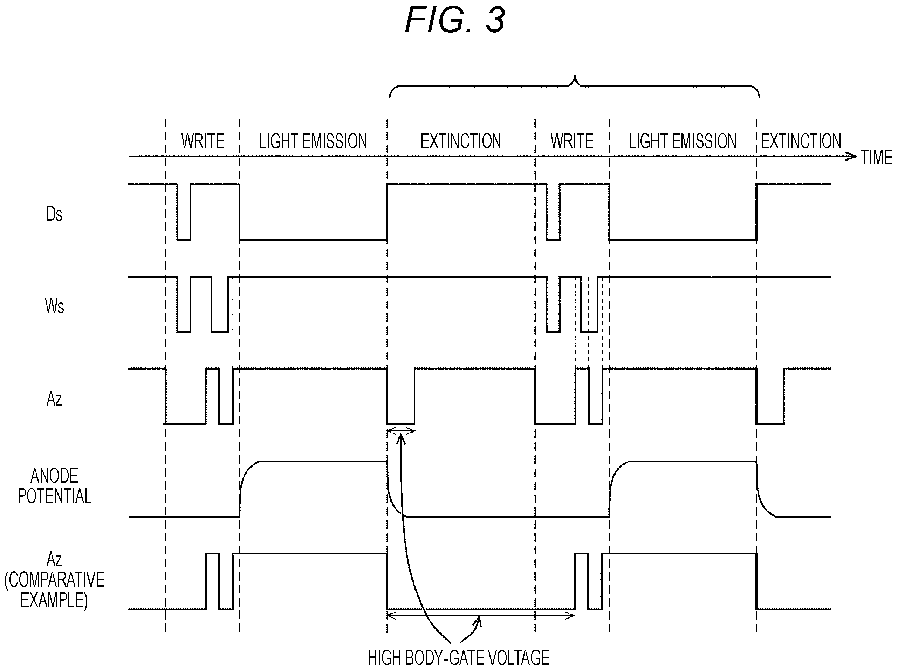

Fig. 3 illustrates a timing chart for appropriately controlling the discharge timing of the first transistor Taz as described above. Note that the timings illustrated in this drawing is an example, and a signal may not be strictly input at the timing illustrated in this chart. For example, the timing in the write time may be another form as long as the voltage based on the voltage Sig can be accurately written to the first capacitor C1 appropriately.

In Fig. 3, the timings of the drive signal Ds, a write signal Ws, and an initialization signal Az in the present embodiment are illustrated in this order from the top. The fourth row illustrates the potential of the anode of the light emitting element L by these signal controls, and the bottom row illustrates the timings of controlling the initialization signal Az without considering the above as a comparative example.

A period indicated by a square bracket in the drawing will be described.

When the light emission period in the previous state ends, the process shifts to an extinction period. At this timing, the drive signal Ds shifts from Low (ON) to High (OFF), and the initialization signal Az shifts from High (OFF) to Low (ON) while the write signal Ws remains High (OFF). As a result of transition to this state, the first transistor Taz is turned on, the second transistor Tws is turned off, and the third transistor Tds is turned off. As a result, the first capacitor C1 is discharged via the first transistor Taz, and the anode potential of the light emitting element L is lowered, so that the light emitting element L is quenched.

After the timing at which the anode potential is sufficiently lowered, the initialization signal Az transitions to High (OFF). This transition makes the potential difference between the body and the gate of the first transistor Taz small. In contrast, in the comparative example, since the initialization signal Az remains Low (ON) during the extinction period, the time during which the potential difference between the body and the gate of the first transistor Taz remains large is longer than that in the present embodiment. The period during which the anode potential is sufficiently lowered is determined depending on, for example, circuit elements such as the first transistor Taz. Therefore, it is possible to set the time for switching the initialization signal Az according to the parameters of the circuit elements.

Thereafter, the process proceeds to a write period for preparing for the next light emission. Upon shifting to the write period, first, the initialization signal Az is set to Low (ON) again. By temporarily setting the initialization signal Az to Low in this manner, the first transistor Taz is turned on, and the state of the circuit due to a leakage current or the like is reset.

Next, by setting the drive signal Ds and the write signal Ws to Low (ON) in a state where the first transistor Taz is turned on, the second transistor Tws, the third transistor Tds, and the fourth transistor Tdr are also reset.

After the reset is completed, the drive signal Ds and the write signal Ws are set to High, and then the initialization signal Az is set to High. Subsequently, the second transistor Tws is turned on by setting the write signal Ws to Low. Thereafter, the initialization signal Az is set to Low again, and the drain potential of the fourth transistor Tdr is reset. This state allows the voltage based on the signal Sig is charged to the gate of the fourth transistor Tdr via the second transistor Tws that is turned on. Then, while the write signal Wr is set to High to maintain the gate potential of the fourth transistor Tdr, the initialization signal Az is set to High to release the ground of the drain of the fourth transistor Tdr.

In this state, transition is made to a light emission period. In the light emission period, by setting the drive signal Ds to Low, the second transistor Tws is turned off, and the third transistor Tds is turned on. When the third transistor Tds is turned on, the source potential of the fourth transistor Tdr increases, and a current based on the gate voltage of the fourth transistor Tdr flows from the anode to the cathode of the light emitting element L. Thus, the light emitting element L emits light with intensity based on the voltage of the signal Sig.

Thereafter, the process shifts to an extinction period, and the control described above is repeated.

According to the present embodiment, such a form enables the potential difference between the body and the gate of the first transistor Taz in the extinction period to be small. For example, as indicated by an arrow in Fig. 3, by controlling the initialization signal Az in the extinction period as in the present embodiment, it is possible to avoid applying a high voltage for a long period to the first transistor Taz and reduce the load. Therefore, in a low duty control in which the light emission period is relatively longer than the extinction period, it is possible to secure the long life and high reliability of the first transistor Taz by executing the control according to the present embodiment.

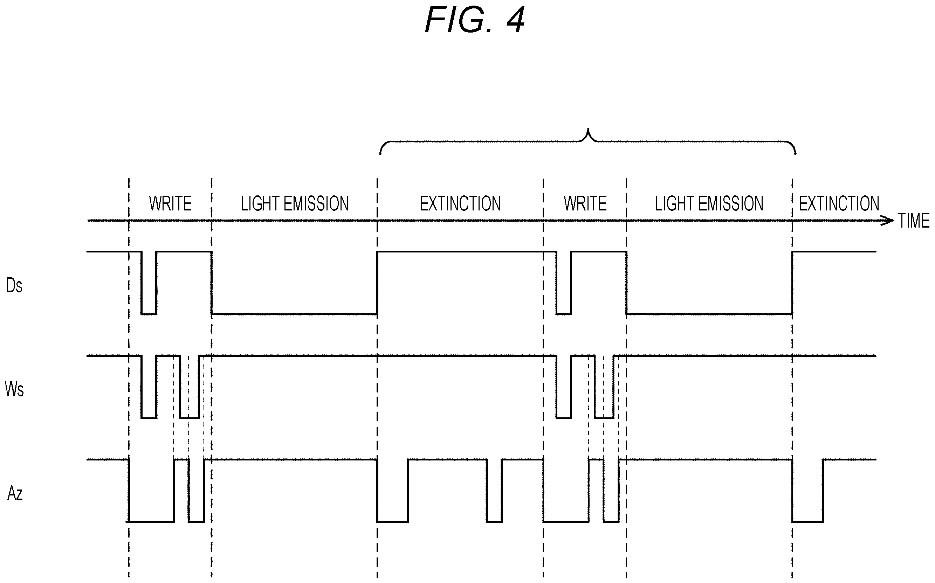

Note that it is not necessary to keep the initialization signal Az high continuously during the extinction period as illustrated in Fig. 3. Fig. 4 is a timing chart illustrating another example of the control of the initialization signal Az. As illustrated in Fig. 4, during the extinction period of the initialization signal Az, the initialization signal Az may be set to High as in the above-described embodiment, and the initialization signal Az may transition to Low and High at predetermined timings. By performing control in this manner, it is also possible to reduce an influence of an undesirable charge or the like to the capacitor due to a leakage current or the like in each transistor. Note that in Fig. 4, the transition between ON and OFF is performed once; however, the present invention is not limited thereto, and transition may be appropriately performed a plurality of times.

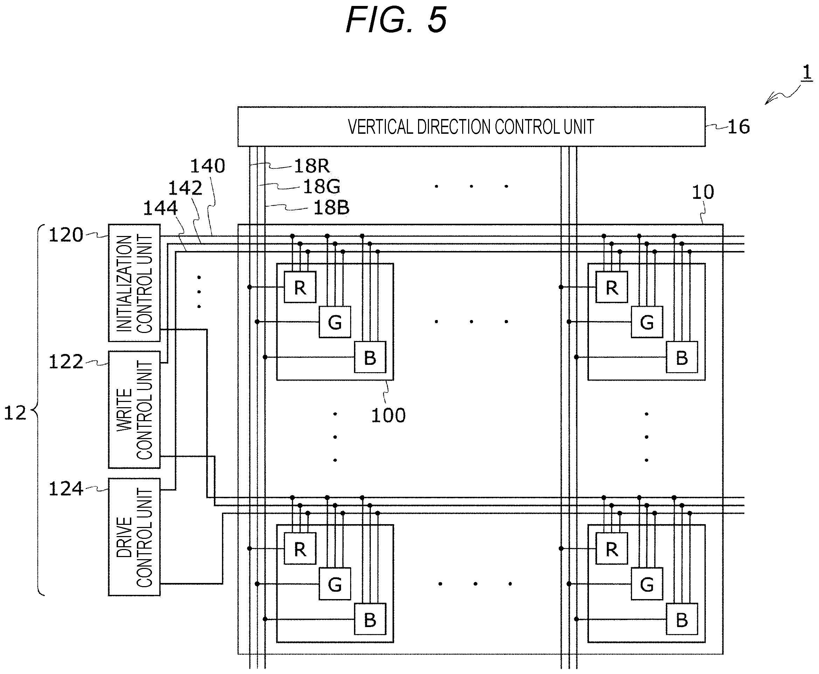

Fig. 5 is a diagram illustrating the display device 1 for supplying a signal to the circuit as illustrated in Fig. 2, for example. Fig. 5 is a diagram illustrating part of the display device 1 illustrated in Fig. 1 in more detail. Each of the control units illustrated in Fig. 5 may be formed by an analog or digital circuit.

The pixel 100 includes, for example, the light emitting element L that emits light of different colors to output a color video. The light emitting element L may be implemented by including a color filter, an organic photoelectric conversion film, or the like corresponding to each color. As a non-limiting example, the pixel 100 may include an R element that emits red light, a G element that emits green light, and a B element that emits blue light. It is needless to say that other combinations may be used, or combinations of four or more colors may be used. The arrangement of the RGB elements may be, for example, a Bayer array, a checkered array, or the like, or may be another array three-dimensionally.

As a non-limiting example, the horizontal direction control unit 12 and the vertical direction control unit 16 output signals to elements corresponding to the respective colors. Each of the elements corresponding to the respective colors may have, for example, a configuration as illustrated in Fig. 2.

The horizontal direction control unit 12 includes an initialization control unit 120, a write control unit 122, and a drive control unit 124. The initialization control unit 120 outputs the initialization signal Az at the timings of the above-described embodiment. The write control unit 122 outputs the write signal Ws at the timings of the above-described embodiment. The drive control unit 124 outputs the drive signal Ds at the timings of the above-described embodiment. These signals are transmitted to the elements in the pixel 100 via horizontal direction control lines 140, 142, and 144 which are each a signal line.

The vertical direction control unit 16 includes, for example, a selector that distributes a signal based on a video signal to the elements of each pixel 100, and outputs an appropriate video signal to the elements of the pixel 100. This video signal is transmitted to the respective elements of the pixel 100 via vertical direction control lines 18R, 18G, and 18B, which are signal lines. Note that the same signal lines are connected to the pixels 100 belonging to the same column (continuous in the vertical direction); however, the present invention is not limited thereto, and signal lines of different systems may be provided in the pixels 100 provided in the same column. For example, signal lines of two systems connected to the same signal line every two columns may be provided for the pixels 100 in the same column.

A video signal output from the vertical direction control unit 16 causes the light emitting element L to emit light in the pixel 100 provided in an appropriate row on the basis of the signal output from each control unit of the horizontal direction control unit 12. Thus, the video signal is appropriately output from the display panel or the like of the display device 1.

In the extinction period of each element of the pixel 100, as in the above-described embodiments, by appropriately controlling the initialization signal Az, it is possible to suppress continuous application of a high load to the first transistor Taz in a continuous period.

As described above, the display device 1 can appropriately display a video or the like while suppressing lowering of reliability of the first transistor Taz that operates as an initialization transistor.

Hereinafter, a circuit in the pixel as illustrated in Fig. 2 will be described with some examples. A region surrounded by a dotted line in Fig. 2 includes the light emitting element L and the first transistor Taz. The operation in the present embodiment can be realized by the arrangement of the light emitting element L and the first transistor Taz.

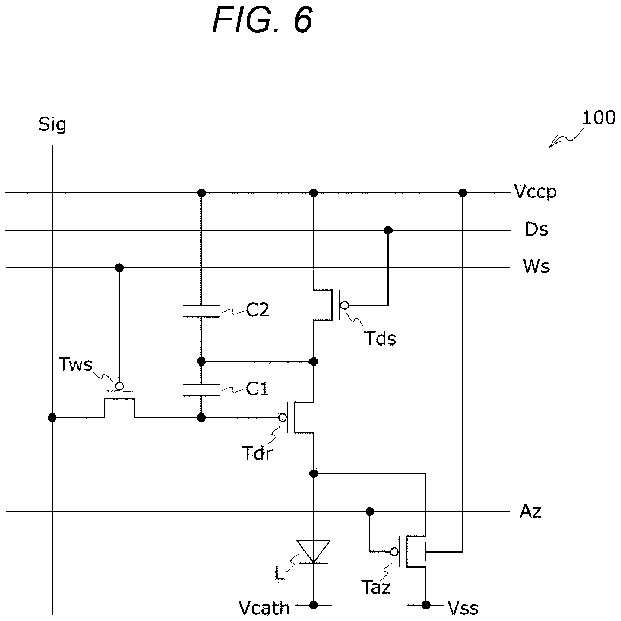

Fig. 6 is a diagram illustrating another example of the pixel 100. In Fig. 2, the configuration includes four transistors and one capacitor; however, in Fig. 6, a pixel 100 includes four transistors and two capacitors.

A second capacitor C2 is a capacitor for charging a voltage corresponding to the signal Sig on the basis of the write signal Ws together with a first capacitor C1. As described above, even if the number of capacitors is changed, the potential of the anode of a light emitting element L is controlled by a first transistor Taz to appropriately perform an extinction operation.

Also in this case, by controlling the initialization signal Az as illustrated in Figs. 3 or 4, it is possible to appropriately control the anode potential of the light emitting element L and to reduce the time during which a high potential is applied between the body and the gate of the first transistor Taz.

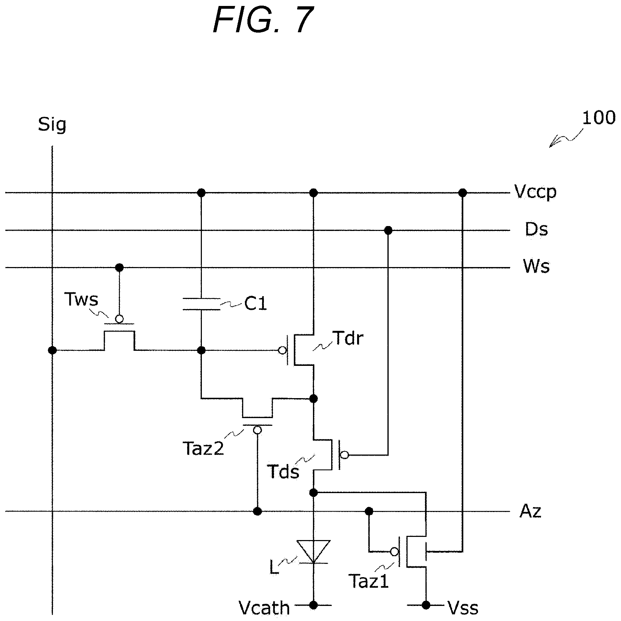

Fig. 7 is a diagram illustrating yet another example of the pixel 100. In Fig. 7, Taz1 and Taz2 are provided as initialization transistors. Also in such a form, a voltage similar to that in each of the above-described forms is applied to Taz1. Furthermore, a similar voltage may be applied also to Taz2 at the same timing.

As described above, by performing control in a similar manner even in a case where a plurality of initialization transistors is present, it is possible to reduce the time during which a high potential is applied between the bodies and the gates of the initialization transistors.

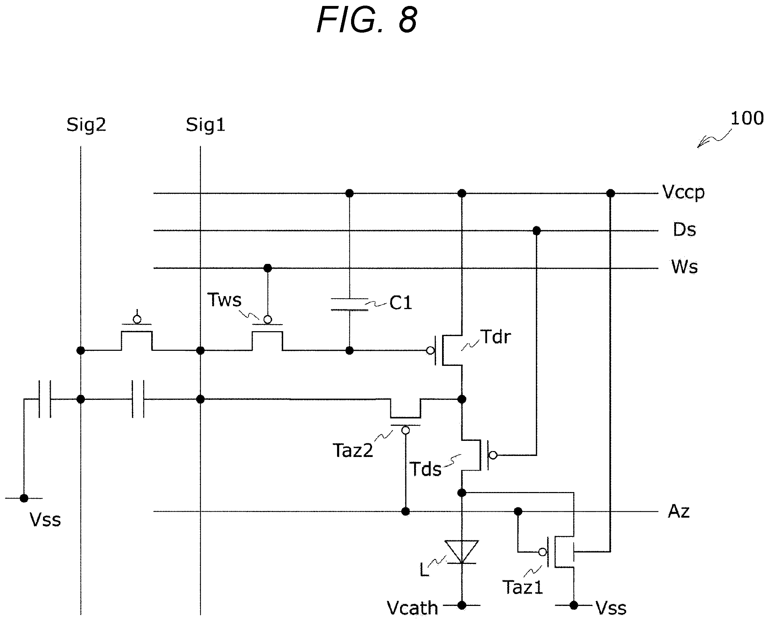

Fig. 8 is a diagram illustrating yet another example of the pixel 100. As illustrated in Fig. 8, even in a case where there are two types of signals indicating the intensity of the pixel, that is, Sig1 and Sig2, similar control can be performed for initialization transistors Taz1 and Taz2.

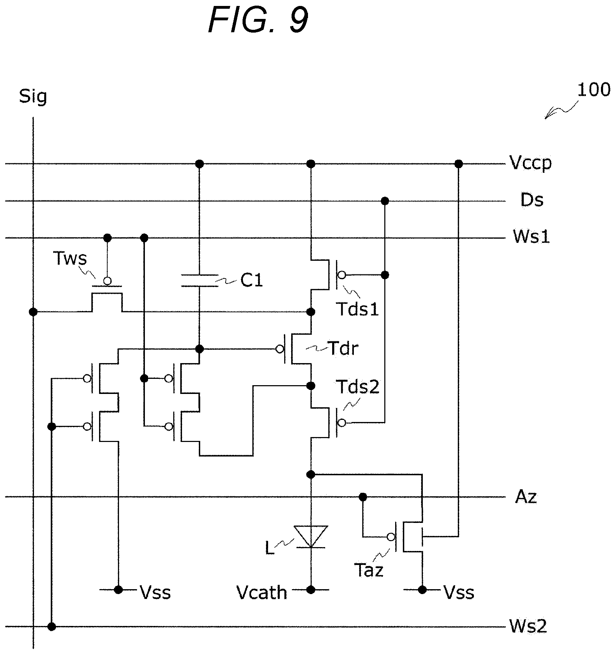

Fig. 9 is a diagram illustrating yet another example of the pixel 100. The pixel 100 is controlled with Ws2, which is a signal for performing write control of a previous line scanned first, as an offset, in addition to Ws1, which is a signal for performing write control of the pixel. As described above, the aspect of the present disclosure can be appropriately applied even to a form depending on control by another line. Moreover, in order to stabilize charging, the pixel 100 includes a write transistor that uses an offset and assists the second transistor Tws. As described above, even in a form in which a plurality of transistors is further provided in the pixel 100 illustrated in Fig. 2 or the like, the control in the aspect of the present disclosure can be applied.

As illustrated in Fig. 9, even in a pixel having a more complicated configuration, a similar effect can be obtained by similarly controlling a gate signal in an initialization transistor in a similar manner as in each of the above-described embodiments.

Although some other examples are illustrated in Figs. 6 to 9, the aspect described in the present disclosure can be applied to an initialization transistor that executes initialization of the anode side of the light emitting element L and other necessary portions so as to be common to all of them. As this configuration, the presence of the initialization transistor related to the light emitting element L in the pixel of the display device 1 and appropriate control of the voltage of the gate of the initialization transistor enable effects similar to those of the present aspect to be achieved. Furthermore, in order to realize this, it is sufficient that initialization of each pixel can be controlled for each line, each column, or each pixel. That is, in a case where there is a circuit configuration as indicated by a dotted line in Fig. 2 as described above, the aspect in the present disclosure can be appropriately applied. As described above, in these drawings, the first transistor Taz has been described as a p-type transistor, but may be an n-type MOSFET. Also in this case, by appropriately controlling the voltage applied to the gate, similar operation can be performed and similar effects can be obtained.

As described above, according to the aspect of the present disclosure, the initialization transistor in which a high voltage is applied between the body and the gate in the on state is not kept in the on state for a long time, but is appropriately switched to the off state, so that long life and high reliability are secured. For example, in a case where there is a pixel having a long period of extinction as in a display used for AR, VR, a digital camera, or the like, high effects can be achieved for a transistor of such a pixel. Also in these other applications, the aspect of the present disclosure can be appropriately applied to a display device including a light emitting element and an initialization transistor that initializes a signal for determining light emission intensity of the light emitting element.

Hereinafter, some non-limiting specific examples of a display device of an image, a video, or the like including the light emitting element that performs control according to the present embodiment will be described. This display device can be mounted on various electronic apparatuses.

### (Specific example 1)

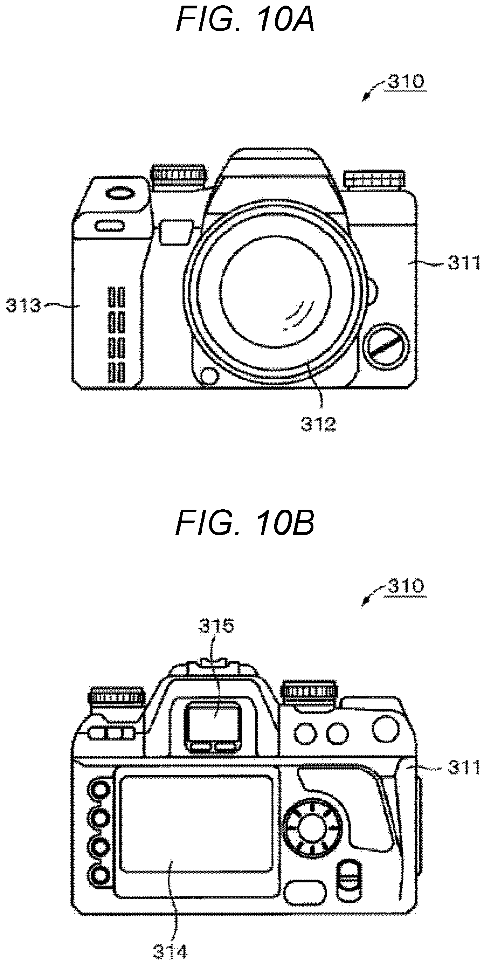

Figs. 10A and 10B illustrate an example of an external appearance of a digital still camera 310. The digital still camera 310 is of a lens interchangeable single lens reflex type, and includes an interchangeable imaging lens unit (interchangeable lens) 312 substantially at the center on the front surface of a camera main body portion (camera body) 311, and a grip portion 313 to be held by a photographer on a front left side.

A monitor 314 is provided at a location shifted to the left from the center of the rear surface of the camera main body portion 311. An electronic viewfinder (eyepiece window) 315 is provided above the monitor 314. By looking through the electronic viewfinder 316, the photographer can visually confirm a light image of the subject guided from the imaging lens unit 312 and determine a picture composition. As the electronic viewfinder 315, the display device 1 according to one of the above-described embodiment and modifications thereof can be used.

### (Specific example 2)

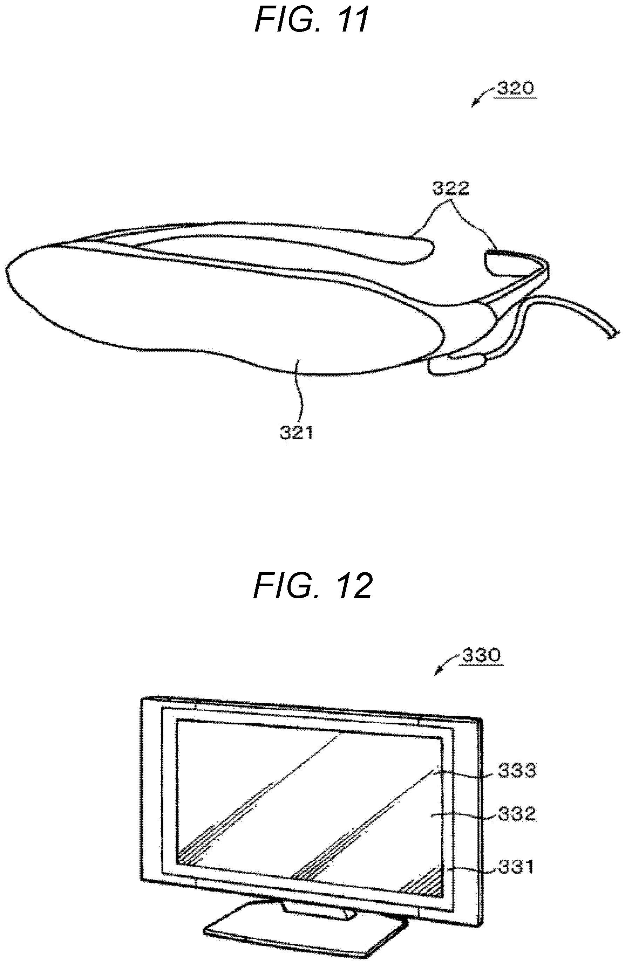

Fig. 11 illustrates an example of an external appearance of a head mounted display 320. The head mounted display 320 includes, for example, ear hooking portions 322 to be worn on the head of the user on both sides of a glass-shaped display unit 321. As the display unit 321, any display device 10 according to one of the above-described embodiment and modifications thereof can be used.

### (Specific example 3)

Fig. 12 illustrates an example of an external appearance of a television device 330. The television device 330 includes, for example, a video display screen unit 331 including a front panel 332 and a filter glass 333, and the video display screen unit 331 includes the display device 1 according to one of the above-described embodiment and modifications thereof.

### (Specific example 4)

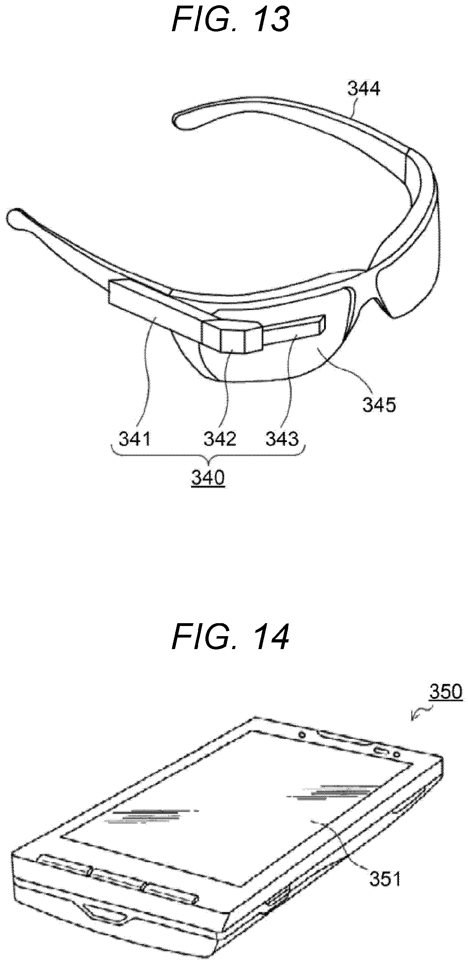

Fig. 13 is an external view illustrating another example of the head mounted display according to a specific example of the electronic apparatus of the present disclosure.

A head mounted display 340 has a transmission type head mounted display configuration having a main body portion 341, an arm portion 342, and a lens barrel 343. The main body portion 341 is connected to the arm portion 342 and glasses 344. Specifically, an end of the main body portion 341 in a long side direction is attached to the arm portion 342. Furthermore, one side of a side surface of the main body portion 341 is connected to the glasses 344 via a connecting member (not illustrated). Furthermore, the main body portion 341 may be directly mounted on the head of a human body.

The main body portion 341 incorporates a control board and a display unit for controlling operation of the head mounted display 340. The arm portion 342 supports the lens barrel 343 with respect to the main body portion 341 by connecting the main body portion 341 to the lens barrel 343. Specifically, the arm portion 342 is connected to the end portion of the main body portion 341 and an end portion of the lens barrel 343 to fix the lens barrel 343 with respect to the main body portion 341. Furthermore, the arm portion 342 incorporates a signal line for communicating data related to an image provided from the main body portion 341 to the lens barrel 343.

The lens barrel 343 projects image light provided from the main body portion 341 via the arm portion 342 through a lens 345 of the glasses 344 toward an eye of the user wearing the head mounted display 340.

### (Specific example 5)

Fig. 14 illustrates an example of an external appearance of a smartphone according to a specific example of the electronic apparatus of the present disclosure. The display device 1 according to the present disclosure can be applied to a display unit included in an electronic apparatus such as a smartphone. Specifically, as illustrated in Fig. 14, a smartphone 350 includes a display unit 351 that displays various kinds of information, an operating unit that includes buttons and the like for receiving an operating input by the user, and the like. The display unit 351 described above can be the display device 1 according to the present embodiment.

### (Specific example 6)

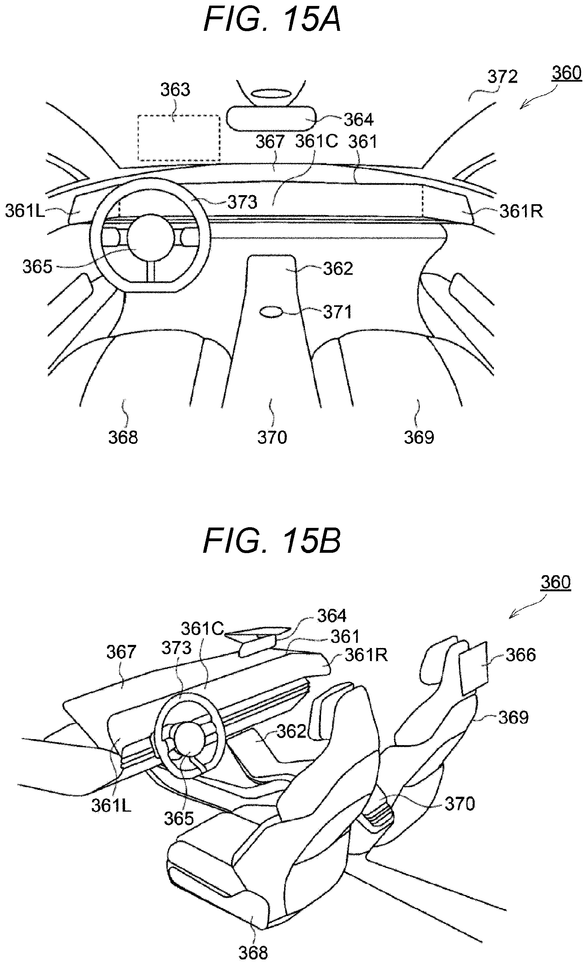

Figs. 15A and 15B illustrate an example in which the display device of the present disclosure is applied to a transport. The display device 1 and the electronic apparatus according to the present disclosure can be used for various applications. Figs. 15A and 15B are views illustrating an internal configuration of a transport 360 which is an application example of the electronic apparatus including the display device 1 according to the present disclosure. Fig. 15A is a view illustrating an internal state from a publication to the front of the transport 360, and Fig. 15B is a view illustrating the internal state from an oblique rear to an oblique front of the transport 360.

The transport 360 in Figs. 15A and 15B includes a center display 361, a console display 362, a head-up display 363, a digital rearview mirror 364, a steering wheel display 365, and a rear entertainment display 366.

The center display 361 is disposed on a dashboard 367 at a location facing a driver's seat 368 and a passenger seat 369. Fig. 15 illustrates an example of the center display 361 having a horizontally long shape extending from the driver's seat 368 side to the passenger seat 369 side; however, the screen size and the arrangement location of the center display 361 are arbitrary. The center display 361 can display information detected by various sensors. As a specific example, the center display 361 can display a captured image captured by an image sensor, a distance image to an obstacle in front of or on a side of the transport measured by a ToF sensor, a passenger's body temperature detected by an infrared sensor, and the like. The center display 361 can be used to display, for example, at least one of safety-related information, operation-related information, a lifelog, health-related information, authentication/identification-related information, or entertainment-related information.

The safety-related information is information on doze detection, looking-away detection, mischief detection of a child riding in the transport, whether or not a seatbelt is fastened, and detection of leaving of an occupant, or the like, and is, for example, information detected by a sensor disposed to overlap the back surface side of the center display 361. The operation-related information detects a gesture related to operation of an occupant by using a sensor. The detected gesture may include operation of various equipment in the transport 360. For example, operations of air conditioning equipment, a navigation device, an AV device, a lighting device, and the like are detected. The lifelog includes lifelogs of all the occupants. For example, the lifelog includes an action record of each occupant in the transport. By acquiring and storing the lifelog, it is possible to check the state of the occupant at the time of an accident. The health-related information detects the body temperature of an occupant by using a temperature sensor, and estimates the health condition of the occupant on the basis of the detected body temperature. Alternatively, the face of an occupant may be imaged by using an image sensor, and the health condition of the occupant may be estimated from the imaged facial expression. Moreover, a conversation may be made with an occupant in an automatic voice, and the health condition of the occupant may be estimated on the basis of the answer content of the occupant. The authentication/identification-related information includes a keyless entry function of performing face authentication by using a sensor, an automatic adjustment function of a sheet height and position in face identification, and the like. The entertainment-related information includes a function of detecting operation information of the AV device by an occupant by using the sensor, a function of recognizing the face of an occupant by the sensor and providing content suitable for the occupant by the AV device, and the like.

The console display 362 can be used to display the lifelog information, for example. The console display 362 is disposed near a shift lever 371 of a center console 370 between the driver's seat 368 and the passenger seat 369. The console display 362 can also display information detected by various sensors. Furthermore, the console display 362 may display an image of the periphery of the vehicle captured by the image sensor, or may display a distance image to an obstacle in the periphery of the vehicle.

The head-up display 363 is virtually displayed behind a windshield 372 in front of the driver's seat 368. The head-up display 363 can be used to display, for example, at least one of the safety-related information, the operation-related information, the lifelog, the health-related information, the authentication/identification-related information, or the entertainment-related information. Since the head-up display 363 is virtually arranged in front of the driver's seat 368 in many cases, it is suitable for displaying information directly related to operation of the transport 360 such as the speed, the remaining amount of fuel (battery), and the like of the transport 360.

The digital rearview mirror 364 can not only display the rear of the transport 360 but also display the state of the occupant in the rear seat, and thus can be used to display the lifelog information, for example, by disposing a sensor on the back surface side of the digital rearview mirror 364 in an overlapping manner.

The steering wheel display 365 is disposed near the center of a steering wheel 373 of the transport 360. The steering wheel display 365 can be used to display, for example, at least one of the safety-related information, the operation-related information, the lifelog, the health-related information, the authentication/identification-related information, or the entertainment-related information. In particular, since the steering wheel display 365 is close to driver's hands, it is suitable for displaying the lifelog information such as the body temperature of the driver, or for displaying information regarding operation of the AV device, the air conditioning equipment, or the like.

The rear entertainment display 366 is attached to the back side of the driver's seat 368 or the passenger seat 369, and is for viewing/listening by the occupant in the rear seat. The rear entertainment display 366 can be used to display, for example, at least one of safety management information, the operation-related information, the lifelog, the health-related information, the authentication/identification-related information, or the entertainment-related information. In particular, a result of measuring the body temperature or the like of the occupant in the rear seat by the temperature sensor may be displayed.

As described above, disposing a sensor on the back surface side of the display device 1 makes it possible to measure the distance to an object existing in the surroundings. Optical distance measurement methods are roughly classified into a passive type and an active type. The passive type measures a distance by receiving light from an object without projecting light from a sensor to the object. Examples of the passive type include a lens focus method, a stereo method, a monocular vision method, and the like. The active type measures a distance by projecting light to an object and receiving reflected light from the object by a sensor. Examples of the active type includes an optical radar system, an active stereo system, an illuminance difference stereo method, a moire topography method, an interference method, and the like. The display device 1 according to the present disclosure is applicable to any of distance measurement of these systems. The above-described passive-type or active-type distance measurement can be performed by using a sensor disposed to overlap the surface side of the image display device 1 according to the present disclosure.

The embodiments described above may have the following forms.

(1) A display device including a control circuit that
   controls a transistor to be turned off in a case where a light emitting element emits light, the transistor being connected to a terminal to which signals for determining driving and light emission intensity of the light emitting element are applied and initializing the signal for determining the light emission intensity, and
   controls the transistor to be turned on and then controls the transistor to be turned off in a case where the light emitting element shifts to an extinction state.
(2) The display device according to (1), in which the control circuit
   controls the transistor to be turned off after the signal for determining the light emission intensity is initialized after the light emitting element shifts to the extinction state and the transistor is controlled to be turned on.
(3) The display device according to (2), in which the control circuit
   controls the transistor to be turned on at a predetermined timing after the transistor is controlled to be turned off in a case where the light emitting element is in the extinction state.
(4) The display device according to any one of (1) to (3),
   in which the light emitting element is an element that emits light by passing a current from an anode to a cathode, and
   the transistor is connected to the anode of the light emitting element.
(5) The display device according to (4), in which the transistor is a p-type MOSFET, a source is connected to the anode, a reference voltage is applied to a drain, and a voltage for controlling on and off of the transistor is applied to a gate.
(6) The display device according to (4), in which the transistor is an n-type MOSFET, a drain is connected to the anode, a reference voltage is applied to a source, and a voltage for controlling on and off of the transistor is applied to a gate.
(7) A method of controlling a display device including:
   controlling a transistor to be turned off in a case where a light emitting element emits light, the transistor being connected to a terminal to which signals for determining driving and light emission intensity of the light emitting element are applied and initializing the signal for determining the light emission intensity; and
   controlling the transistor to be turned on and then controlling the transistor to be turned off in a case where the light emitting element shifts to an extinction state.
(8) The control circuit according to any one of (1) to (5) .
(9) A pixel circuit including the control circuit according to any one of (1) to (5).
(10) The display device according to any one of (1) to (5) being used for an AR application, a VR application, and a display application of a digital camera.

Aspects of the present disclosure are not limited to the above-described embodiments, and include various conceivable modifications. The effects of the present disclosure are not limited to the above-described contents. The components in each embodiment may be appropriately combined and applied. That is, various additions, modifications, and partial deletions can be made without departing from the conceptual idea and gist of the present disclosure derived from the contents defined in the claims and equivalents thereof.

### REFERENCE SIGNS LIST

- 1: Display device
- 10: Pixel array
- 100: Pixel
- Taz, Tws, Tds, Tdr: Transistor
- C1, C2: Capacitor
- L: Light emitting element
- 12: Horizontal direction control unit
- 120: Initialization control unit
- 122: Write control unit
- 124: Drive control unit
- 14, 140, 142, 144: Horizontal direction control line
- 16: Vertical direction control unit
- 18, 18R, 18G, 18B: Vertical direction control line
- 310: Digital still camera
- 311: Camera body
- 312: Interchangeable lens
- 313: Grip portion
- 314: Monitor
- 315: Eyepiece window
- 320: Head mounted display
- 321: Display unit
- 322: Ear hooking portion
- 330: Television device
- 331: Video display screen unit
- 332: Front panel
- 333: Filter glass
- 340: Head mounted display
- 341: Main body portion
- 342: Arm portion
- 343: Lens barrel
- 344: Glasses
- 345: Lens
- 350: Smartphone
- 351: Display unit
- 360: Transport
- 361: Center display
- 362: Console display
- 363: Head-up display
- 364: Digital rearview mirror
- 365: Steering wheel display
- 366: Rear entertainment display
- 367: Dashboard
- 368: Driver's seat
- 369: Passenger seat
- 370: Center console
- 371: Shift lever
- 372: Windshield
- 373: Steering wheel

## Claims

1. A display device comprising a control circuit that
controls a transistor to be turned off in a case where a light emitting element emits light, the transistor being connected to a terminal to which signals for determining driving and light emission intensity of the light emitting element are applied and initializing the signal for determining the light emission intensity, and
controls the transistor to be turned on and then controls the transistor to be turned off in a case where the light emitting element shifts to an extinction state.

2. The display device according to claim 1, wherein the control circuit
controls the transistor to be turned off after the signal for determining the light emission intensity is initialized after the light emitting element shifts to the extinction state and the transistor is controlled to be turned on.

3. The display device according to claim 2, wherein the control circuit
controls the transistor to be turned on at a predetermined timing after the transistor is controlled to be turned off in a case where the light emitting element is in the extinction state.

4. The display device according to claim 1, wherein the light emitting element is an element that emits light by passing a current from an anode to a cathode, and
the transistor is connected to the anode of the light emitting element.

5. The display device according to claim 4, wherein the transistor is a p-type MOSFET, a source is connected to the anode, a reference voltage is applied to a drain, and a voltage for controlling on and off of the transistor is applied to a gate.

6. The display device according to claim 4, wherein the transistor is an n-type MOSFET, a drain is connected to the anode, a reference voltage is applied to a source, and a voltage for controlling on and off of the transistor is applied to a gate.

7. A method of controlling a display device comprising:
controlling a transistor to be turned off in a case where a light emitting element emits light, the transistor being connected to a terminal to which signals for determining driving and light emission intensity of the light emitting element are applied and initializing the signal for determining the light emission intensity; and
controlling the transistor to be turned on and then controlling the transistor to be turned off in a case where the light emitting element shifts to an extinction state.
